# EUROPEAN PATENT APPLICATION

(11) **EP 4 531 511 A1**
(43) Date of publication of application: **02.04.2025**
(21) Application number: 24190436.6
(22) Date of filing: 23.07.2024
(51) Int. Cl.: H05K 7/20

(54) **IMMERSION COOLING SYSTEM WITH MULTIPLE COOLING LIQUIDS**

(30) Priority: 29.09.2023 US 202318375056
(71) Applicant: INTEL Corporation, Santa Clara, CA 95054 (US)
(72) Inventor: AHUJA, Sandeep, Portland, 97229 (US); CHANG, Je-Young, Tempe, 85283 (US); KLEMES, Max, Hillsboro, 97124 (US); MITRA, Arpita, Chandler, 85248 (US)
(74) Representative: Maiwald GmbH

(57) **Abstract**

An apparatus is described. The apparatus includes a chamber to contain one or more electronic components, a first liquid and a second liquid. The electronics to be immersed in the second liquid. The first liquid having less density than the second liquid so that the first liquid floats above the second liquid. The first liquid to return second liquid molecules received from the second liquid back to the second liquid. The chamber comprising a first fluidic channel to drain the first liquid from the chamber while the second liquid is within the chamber.

## Description

### BACKGROUND

With the emergence of high performance centralized computing (such as cloud computing, artificial intelligence, big data computing, etc.) the computational demands being placed on the underlying electronics cause the electronics to generate significant amounts of heat. As such, engineers are focused on improving the ways in which heat can be removed from the electronics.

### BRIEF DESCRIPTION OF THE FIGURES

Fig. 1 shows an immersion cooling system;
Fig. 2 shows an improved immersion cooling system;
Fig. 3 shows a more detailed embodiment of an improved immersion cooling system;
Fig. 4 shows a detailed embodiment of an improved two-phase immersion cooling system;
Fig. 5 shows a data center.

### DETAILED DESCRIPTION

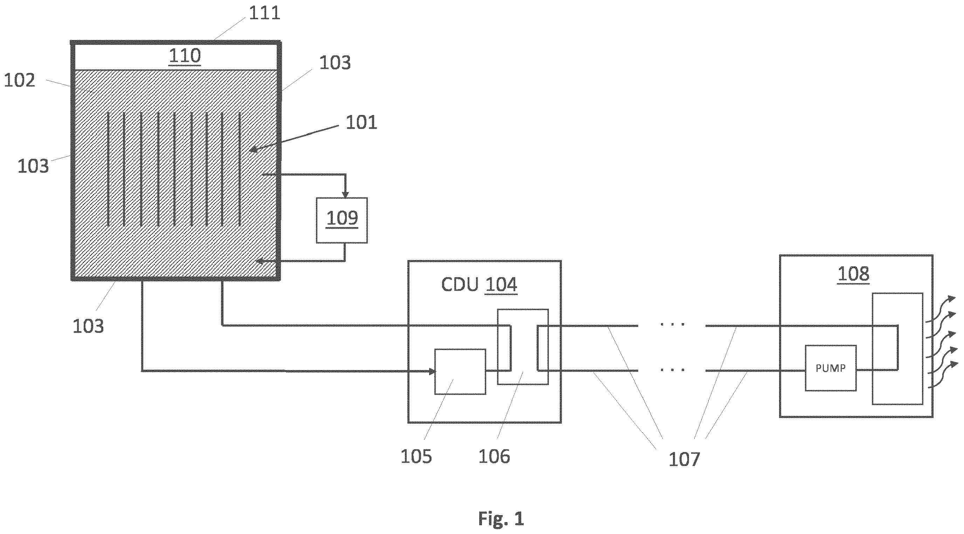

Fig. 1 depicts an immersion cooling system. As observed in Fig. 1, a plurality of electronic circuit boards 101 are immersed in a dielectric liquid 102 that electrically isolates the exposed electrical nodes of the electronic circuit boards 101 and their respective electronic components (Fig. 1 depicts a side view of the circuit boards 101 oriented vertically within the liquid 102). The electronic components, when in operation, generate heat which is transferred to the liquid 102. The liquid 102 has a higher heat transfer coefficient than air which enables heat to be removed from the electrical components more effectively than would otherwise be achievable in an air-cooled environment. A filtration system 109 is coupled to the immersion bath chamber 103 to remove contaminants from the liquid 102.

The immersion bath chamber 103 is also fluidically coupled to a coolant distribution unit (CDU) 104 that includes a pump 105 and heat exchanger 106. During continued operation of the electronic components, the liquid's temperature will rise as a consequence of the heat it receives from the operating electronics 101. The pump 105 draws the warmed liquid 102 from the immersion bath chamber 103 to the heat exchanger 106. The heat exchanger 106 transfers heat from the warmed fluid to secondary liquid within a secondary cooling loop 107 that is fluidically coupled to a cooling tower and/or chilling unit 108. The removal of the heat from the liquid 102 by the heat exchanger 106 reduces the temperature of the liquid which is then returned to the chamber 103 as cooled liquid.

In a high computing environment, such as a data center, the respective CDUs of multiple immersion bath chambers are coupled to the secondary loop 107, and, the cooling tower and/or chilling unit 108 removes the heat generated by the electronics within the multiple immersion bath chambers from the data center.

Preferable properties of the immersion bath liquid 102 include (apart from high specific heat and high electrical insulation) high boiling point and correspondingly low vapor pressure (the pressure exerted on the ambient 110 above the liquid 102 by gaseous phase molecules of the liquid 102 that are trying to escape the liquid 102). Liquids that adequately meet these criteria, however, nevertheless exhibit some persistent vapor pressure resulting in persistent loss of liquid material that escapes the bath 103 in a gaseous phase and enters the ambient 110.

Unfortunately, the immersion bath chamber 103 is not hermetically sealed (is not "airtight"). Here, a number of cables (not shown in Fig. 1) that connect to the electronics 101 are routed through holes in the sidewalls of the chamber 103 and/or the chamber's lid 111. As a consequence, in combination with the aforementioned persistent vaporization of the liquid 102, a significant amount of liquid 102 material escapes the chamber 103 (e.g., through the aforementioned chamber holes) over an extended run time of the operating electronics 101.

The significant loss of immersion bath material is also exacerbated anytime the lid 111 is opened (e.g., to insert/remove an electronic circuit board and/or connect/remove a cable to/from an electronic circuit board).

The persistent loss of liquid material from the system requires the liquid 102 to be regularly replenished. Because the liquid 102 itself can be expensive, the continued loss and replenishment of significant amounts of the liquid material results in a higher cost of operation of the immersion cooling system. Moreover, some of the more effective heat transfer immersion cooling liquids are not environment friendly (e.g., have high global warming potential (GWP) and/or include per- and polyfluoroalkyl (PFAS) chemicals). Thus, the persistent loss of liquid material from the system can not only raise the system's monetary costs but also can also contribute to environmental issues.

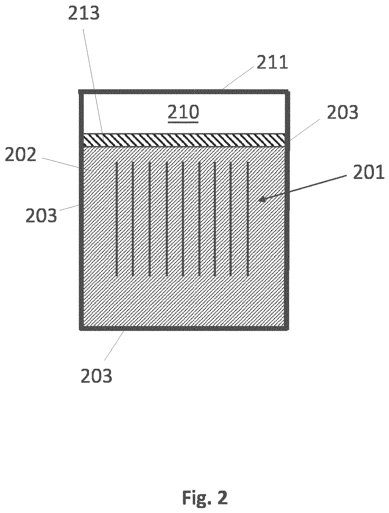

A solution, as observed in Fig. 2, is to introduce a "cap layer" of liquid 213 (upper liquid) within the chamber 203 along with the nominal dielectric immersion cooling liquid 202 (lower liquid). The upper liquid 213 should: 1) be composed of molecules that (e.g., strongly) prefer to bind with one another rather than with the molecules of the lower liquid 202; 2) have lower density than the lower liquid 202; and 3) be environment friendly (e.g., be PFAS free so that it exhibits low GWP). Notably, the first two properties above will cause the upper liquid 213 and the lower liquid 213 to be immiscible or near immiscible (they do not mix or mix very little) with the upper layer 213 floating on top of the lower liquid 202.

During operation, the upper liquid 213 substantially prevents lower liquid 202 molecules from reaching the ambient 210. Here, as per nominal evaporation when the temperature of a liquid is below its boiling point, collisions of lower liquid molecules 202 at the interface of lower liquid 202 and upper liquid 213 can have sufficient energy to escape the lower liquid 202 and enter the upper liquid 213. However, the relative immiscibility between the lower liquid 202 molecules and the upper liquid 213 molecules and/or the higher density of the lower liquid 202 molecules as compared to the upper liquid 213 molecules will cause any such high energy escaped lower liquid 202 molecules that reach the upper liquid 213 to be "pushed" back down into the lower liquid 202 from the upper liquid 213, thereby preventing the lower liquid molecules from reaching the ambient 210.

As a consequence, the above described approach allows the use of a lower liquid 202 that exhibits higher heat removal capability, is PFAS and/or has greater GWP risk than other immersion bath coolants that are more commonly used, e.g., because of being PFAS-free and/or lower GWP risk. The use of lower liquid 202, having higher heat removal capability than the more commonly used immersion cooling fluids improves the heat removal efficiency of the overall system.

In various embodiments, the upper liquid 213 also has high boiling point and exhibits low vapor pressure, at least for a less dense (light) liquid, so that the upper liquid 213 remains in the liquid phase during operation and pushes any lower liquid 202 molecules that escape the lower liquid 202 back into the lower liquid 202. Alternatively or in combination, in various embodiments, the upper liquid 213 is PFAS-free and/or exhibits very low GWP risk (at least substantially lower GWP risk than the lower liquid 202) so that any vaporization of the upper liquid 213 only results in minimal GWP risk (if any).

For ease of illustration, Fig. 2 does not show the filtration system 109 of Fig. 1 or the entrance/exit ports for cool/warm fluid entrance/exit to/from the system, nor an external CDU and cooling tower/chilling unit as observed in Fig. 1. These components can nevertheless be integrated with the chamber of Fig. 2 to effect a complete working system.

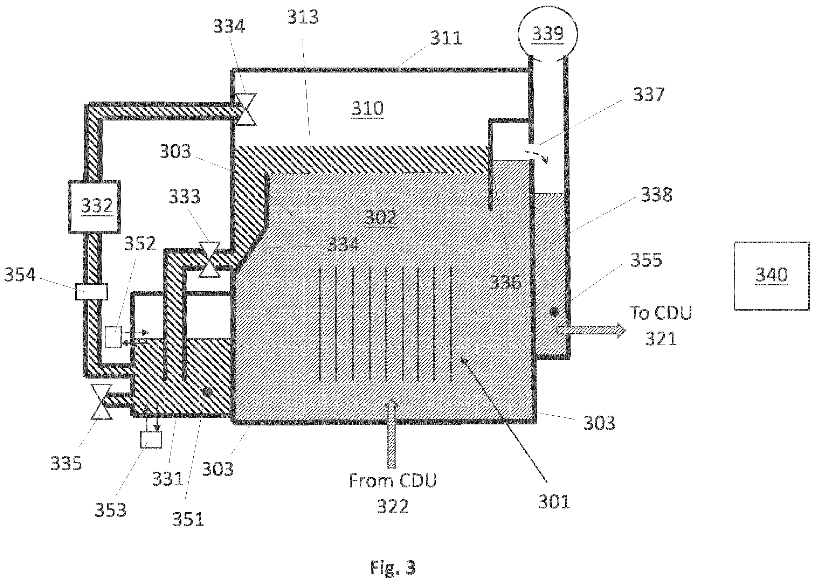

Fig. 3 shows an embodiment of an immersion chamber system designed to contain two different liquids 313, 302 as described just above. The particular immersion chamber 303 of Fig. 3 is designed, as described immediately below, to: 1) accommodate the removal of the upper liquid 313 while leaving the lower liquid 302 within the chamber 303 (e.g., to service the electronics 301 within the lower liquid 302); 2) accommodate for thermal expansion of the lower liquid 302; and, 3) accommodate the flow 321 of warmed lower liquid 302 from the chamber 303 toward a CDU and the return of cooled lower liquid 302 back into the chamber 303.

With respect to 1) above, as observed in Fig. 3, the upper liquid 313 has its own dedicated reservoir 331, pump 332 and corresponding fluidic channels so that the upper liquid 313 can be drained from the chamber 303 while keeping the lower liquid 302 in the chamber.

Draining the upper liquid 313 from the chamber 303 before servicing the electronics 301 in the lower liquid 302 is advisable because the upper liquid 313 can have higher viscosity and/or much lower vapor pressure therefore it would take a longer time to drip away the liquid from the server before permitting the board to be serviced. In contrast, the lower liquid has higher vapor pressure (for example, >0.8 kPa at 25C) and would quickly evaporate leaving little or no visible residue on the electronics 301.

In order to remove the upper liquid 313, valve 333 is opened which causes the upper liquid to drain into reservoir 331. In various embodiments, the volume of reservoir 331 is larger than the maximum volume of the upper liquid 313 so that the upper liquid 313 can be completely drained from the chamber 303 without overflowing the reservoir 331. The fluidic channel between the upper liquid 313 and the reservoir 331 also includes a baffle 334 within the chamber 303 that physically separates the upper liquid 313 from the lower liquid 302. The opening in the chamber wall through which the upper liquid flows while being drained is placed toward the bottom of the fluidic channel formed within the chamber 303 by the baffle 334 so that the upper liquid 313 naturally drains from the chamber 303 due to gravitational force.

After the upper liquid 313 has been drained from the chamber 303 and is within the reservoir 331, valve 333 can be closed. When the time is appropriate to re-introduce the upper liquid 313 back into the chamber 303, e.g., after the electronics 301 have been serviced, valve 333 remains closed, valve 334 is opened and pump 332 is activated. This creates an open channel from the reservoir 331 through the pump 332 to a spigot (controlled by valve 334) that extends into the chamber 303. The upper liquid 313 is then pumped from the reservoir 331 through this open fluidic channel back into the chamber 303. The pump 332 can then be shut off and Valve 334 closed if the fluid level in reservoir 331 drops below a certain level (which is detected using a fluid level sensor 351) and which determines the amount of upper liquid 313 within the chamber 303).

The above described design also allows for the regular filtration of the upper liquid 313, e.g., during nominal operation of the electronics 301 and without any need to service them. In this case, valves 333 and 334 are opened and the pump 332 is activated so that the upper liquid 313 regularly circulates from the chamber 303, into the reservoir 331 from where it is pumped back into the chamber 303 by pump 332. If the rate at which the upper liquid 313 drains from the chamber 303 is equal to the rate at which the upper liquid 313 is pumped back into the chamber 303, the amount of upper liquid within the chamber 303 will remain constant. This condition can be established by controlling the respective sizes of the openings in valves 333, 334, the pump rate of the pump 332, or some combination of these. As a practical matter, if valves 334 and 333 are open and the pump 332 is operating, the pump flow rate should remain lower than the rate at which fluid 313 can drain back in reservoir 331 to ensure the fluid level in the reservoir 331 remains above some minimum desired level. If for some reason, the rate of draining is slower, reservoir 331 will start to empty and the fluid level in reservoir 331 will drop. The fluid sensor 351 within the reservoir 331 can detect the drop to cause the pump 332 to shut off.

One or more particle filters (not shown in Fig. 3) can also be placed any where along the upper liquid's above described fluidic channel to remove contaminants/particles from the upper liquid 313 as it cycles through the fluidic channel.

If contaminants exist with the upper liquid 313, those of the contaminants that are less dense than the upper liquid 313 will float (be buoyant) on the surface of the upper liquid 313 within the reservoir 331, whereas, contaminants that are more dense than the upper liquid 313 will sink to the bottom of the reservoir 331.

As such, additional filtration systems 352, 353 (akin to filtration system 109 of Fig. 1) can be integrated with the reservoir 331 to specifically remove these types of contaminants. Here, for example, an upper filtration system 352 could draw from the upper surface of the fluid within the reservoir 331 (which contains buoyant particles) and pump the drawn fluid through a filter before returning the filtered fluid back to the reservoir 331 (alternatively, the buoyant particles could be siphoned from the upper surface of the fluid within the reservoir 331). Likewise, a lower filtration system 353 could draw fluid from the bottom of the reservoir 331 (which contains particles having greater density than the upper liquid 313), pump the fluid through a filter and return the filtered fluid back to the reservoir 331.

Additionally, when the upper liquid 313 is drained from the chamber 303, it is conceivable that additional contaminants having density greater than the upper liquid 313 but less than the lower liquid 302 will be floating on the top surface of the lower liquid 302 (such particles collect at the interface between the two liquids 313, 302 when both liquids 313, 302 are within the chamber 303). These particles can easily be siphoned off the top surface of the lower liquid 302 after the upper liquid 313 has been drained from the chamber 303 and into the reservoir 331.

Another valve 335 is located toward the bottom of the reservoir 331 which is opened when the upper liquid 313 is to be flushed from the system, e.g., and replaced with new/fresh upper liquid.

Another set of fluidic channels are integrated with the chamber 303 to accommodate the thermal expansion of the lower liquid 302 as well as accommodate for the flows of warmed lower liquid 302 from the chamber 321 (toward the CDU) and return cooled lower liquid (from the CDU) back into the chamber 322.

Here, another baffle 336 forms a fluidic channel to an escape port 337 that is placed above the upper surface of the lower liquid 302 when the lower liquid 302 is receiving little/no heat from the electronics 301 and is therefore in a minimal thermal expansion state. As the electronics increasingly transfer heat into the lower liquid 302, however, the lower liquid 302 will expand in response, including rising within the fluidic channel formed by the baffle 336 toward the escape port 337.

The vertical position (height) of the escape port 337 establishes the maximum height to which the lower liquid 302 will rise within the chamber 303 due to thermal expansion. Here, the narrower width of fluidic channel formed by baffle 336 will cause the expanding lower liquid 302 to rise to a higher level within the channel than within the chamber 303 (the thermal expansion creates greater upward force within the narrower channel).

Once the expanding lower liquid 302 reaches the escape port 337 the lower liquid 302 will begin to flow out of the channel and into an expansion jacket 338 which, in turn, causes the height of the lower liquid 302 within the chamber 303 to remain approximately constant (any further volumetric increase in the lower liquid 302 due to thermal expansion is handled by a loss of an equal amount of lower liquid volume from the chamber 303). A bellows 339 (e.g., an elastic balloon) is mechanically coupled to the expansion jacket 338 to accommodate cases of extreme thermal expansion of the lower liquid 302 in which the volume of the escaped fluid from the chamber 303 exceeds the volume of the expansion jacket 338.

Notably, the height at which the lower liquid 302 remains constant as a consequence of the flow of the expanding lower liquid 302 from the chamber 303 can also establish the height of the baffle 334 for the upper liquid's fluidic channel system. That is, the lower end of the escape port 337 need only extend just above the designed maximum height of the lower liquid 302 in the main chamber 303. The baffle 336 extends below the designed maximum height of the lower liquid 302 to ensure that the upper liquid 313 is physically separated from the lower liquid 302 when the upper liquid 313 is being drained from the chamber 303 and also ensures that the upper liquid 313 cannot enter the expansion jacket 338 and flow to the CDU 321. Notably, because the lower liquid 302 within the narrower fluidic channel formed by baffle 336 will rise to a higher level than the lower liquid 302 within the chamber 303, as observed in Fig. 3, the height of the baffle 334 that forms a fluidic channel for the upper liquid 313 can be below the height of the escape port 337 and baffle 336.

In further embodiments the height of the baffle 334 that forms a fluidic channel for the upper liquid 313 is adjustable so that, e.g., during drainage of the upper liquid 313 from the chamber 303, the height of the baffle 334 can be lowered so that (ideally) all of the upper liquid 313 is drained from the chamber 303. Moreover, should any lower liquid 302 surmount the baffle 334 and flow into the reservoir 331, because the two liquids 313, 302 are immiscible with the lower liquid 302 having greater density than the upper liquid 313, the lower liquid 302 will sink to the bottom of the reservoir 331. Furthermore, note that any contaminant particles that are heavier than upper liquid 313 and lighter than lower liquid 302 will flow into the reservoir 331. When the pump 332 is activated, it will pump the upper fluid 13, the lower fluid 302 that flowed into the reservoir 331, and the contaminants. A filter 354 positioned between the reservoir 331 and the pump 332 will trap these contaminant particles so that they can be removed from the system.

Although the embodiments described above have stressed that the electronics 301 remain within the lower liquid 302, some portion of the electronics 301 can extend into the upper liquid 313 (e.g., the backplane through which input/output cables couple to the circuit boards can be located with the upper liquid 313) as both upper liquid 313 and lower liquid 302 are dielectric fluids.

The system of Fig. 3 also includes a controller 340 that can effect/control any of the operations described just above such as opening/closing/adjusting any of the aforementioned valves 333, 334, 335 and/or controlling the pump rate of pump 332. Moreover, the controller 340 can monitor the conditions within the system to ensure the system is operating correctly. For example, the controller 340 can monitor the quality of the above described filters to detect when filter replacement is appropriate. As another example the controller 340 can monitor fluid levels in the reservoir 331 and, e.g., based on one or more sensors 351 within the reservoir 331, determine when to shut down the pumping activity of the pump 332, etc.. Also, a low fluid level in the expansion jacket 338 (e.g., as detected by a sensor 355 within the expansion jacket volume) can be used by the controller 340 to cause a reduction in the CDU 321 pump flow rate and/or can be used as an indicator that the lower liquid 302 is running low which causes the CDU to raise a flag that the lower liquid needs to be replenished.

The controller 340 can also measure the temperature of the lower liquid 302 (e.g., with one or more thermos-sensors in the chamber) and/or the power consumption of the electronics 301 (e.g., by monitoring electronics workload and/or supply current draw), calculate the expected thermal expansion of the lower liquid 302 in response thereto, and then calculate an expected escape rate of lower liquid 302 from the escape port 337 and/or a resulting level of lower liquid within the expansion jacket 338. The controller 340 can then compare the calculated expected escape rate and/or fluid level to confirm that the expected amount of lower liquid 302 is escaping from the chamber 303.

The controller 340 can also be coupled to sensors (not shown) in the chamber 303 that are positioned at respective heights along a wall of the chamber 303 to detect if the lower liquid 302 falls below a minimum desired level for correct operation and/or rises above a maximum desired level for correct operation. If the minimum or maximum levels are exceeded or are about to be exceeded the controller 340 can raise an alarm.

In various embodiments, the upper liquid 313 is composed of a polyalphaolefin (PAO) (e.g., PAOx where x is within a range of 2 to 8 inclusive); refined mineral oils; gas-to-liquid fluids; iso-paraffins; polyol esters; and silicone oils. Examples include Synfluid PAO2, PAO2.5, PAO3, PAO3.5, PAO4, PAO6, SpectraSyn fluid series, CompuZol, IM2015, Renolin FECC5 Synthetic, Castrol ON BOT 2151, Renolin FECC7, ENEOS fluid, BP DC-15, Shell 3447, DC Cooling BioLife 5, Palub ICE-5 and Dowsil ICL-1202. The upper liquid 313 can also meet sustainability criteria of negligible PFAS and/or zero/low GWP. The upper liquid 313 should also exhibit minimal volatility (e.g., have vapor pressure less than 0.8kPa at 25C). In various embodiments, the lower liquid 302 is composed of fluorochemical fluids (PFAS), perfluorocarbon, perfluoroalkene, perfluoropolyether, fluoroketone, hydrofluorocarbon, hydrofluoroether, and hydrofluoroolefin.

The lower liquid 302 can be composed of PFAS fluids, volatile fluids (e.g., that exhibit vapor pressure greater than 0.8kPa at 25 °C), and/or have superior thermal and signal integrity capabilities such as a dielectric constant of ≤ 2.3 and dielectric loss tangent of ≤ 0.05 from 20MHz to 20GHz to 40GHz over 20 °C to 70 °C. Thus, the lower liquid 302 can be PFAS and/or high GWP (such as ≥ 1). Some examples include Noah 3000A, 3M^{™} Fluorinert^{™} Electronic Liquids (e.g., FC-40, FC-43), Galden^{®} PFPE HT fluids (e.g., HT270) and 3M^{™} Novec^{™} Engineered Fluids (e.g., Novec 7500).

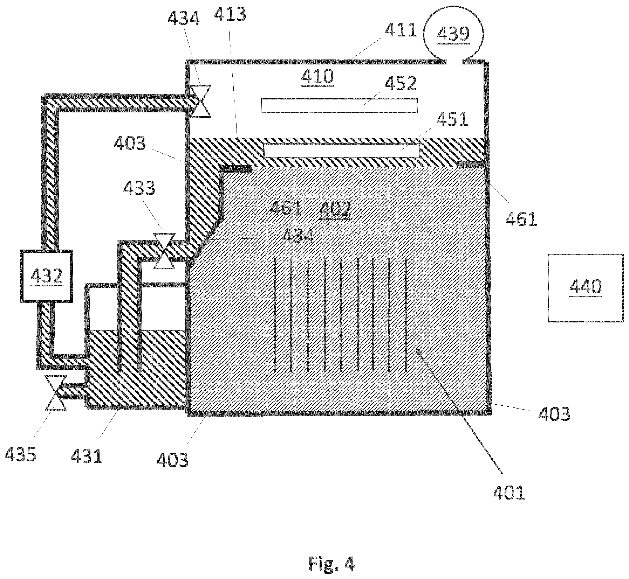

Fig. 4 shows another, similar chamber design that includes many of the features and operating principles of the system described just above with respect to Fig. 3. Specifically, the system of Fig. 4 includes a less dense PFAS-free upper liquid 413 to prevent molecules from a more dense PFAS lower liquid 402 from reaching the ambient 410. Consequently, the baffle 434, reservoir 431, pump 432 and corresponding fluidic channel(s) for the upper liquid 413 are included in the system of Fig. 4.

However, whereas the system of Fig. 3 uses "single phase" cooling approach that cools primarily though convention, by contrast, the chamber system of Fig. 4 applies "two-phase" immersion cooling in which cooling from both boiling and convection are used to remove heat from the electronics 401. Heat is removed from the system by circulating the lower liquid 402 in direct contact with the electronics, whereby the liquid undergoes evaporation due to its lower boiling point to transfer the heat out of the liquid.

In the case of two-phase cooling, when the electronics 401 are dissipating modest amounts of heat, the lower liquid 402 cools the electronics 401 by convection cooling as in single-phase cooling described above. However, when the electronics 401 dissipate larger amounts of heat, the heat absorbed by the lower liquid 402 causes the temperature of the lower liquid 402 to reach its boiling point and the lower liquid 402 boils in response. The bubbles of the vaporized lower liquid 402 rise above the lower liquid 402 and into the upper liquid 413.

A first condenser 451 is placed in the upper liquid 413 and, if needed, also small portion of top layer of lower liquid 402 so that if any vapors accumulate below the upper liquid 413 layer, it effectively cools the vapors back into liquid 402 droplets that fall back into the lower liquid 402. In addition, the first condenser 451 also cools the upper liquid 413 and any heat that the upper liquid 413 receives from the vapor is removed from the system by the first condenser 451. More specifically, the heat is transferred to cooled water within the condenser (not shown) that is warmed in response and then pumped out of the condenser and chamber (not shown), cooled again by an external heat exchanger (not shown) and returned to the condenser 451 as cooled liquid (not shown). The process then continually repeats so that heat is continually removed from the upper liquid 413.

A second condenser 452 that operates according to the same principles as described just above (who warmed water exit and cooled water return is also not shown) is also placed within the ambient 410 above the upper liquid 413. Here, if any of the vapor from the lower liquid 402 is not condensed within the upper liquid 413 by condenser 451 and rises into the ambient 410, the vapor will be cooled by the second condenser 452 into liquid droplets that fall back into the upper liquid 413 and then sink further into the lower liquid 402. The second condenser 452 can also condense any vapor from the upper liquid (if any) back into droplets that fall back into the upper liquid 413.

Chilled facility water can be sent through the condenser 452 first and then the same chilled water can be sent through condenser 451 to exchange heat with the vapors from lower fluid 402. As the chilled water picks up heat within condenser 451, it warms and is pumped out of the condenser 451 and chamber 403 for subsequent cooling.

Importantly, the condensation of the lower liquid's vapor back into a liquid as provided by the first and second condensers 451, 452 greatly diminishes the amount of lower liquid material that will escape the system. As such, operational costs and GWP risks are kept in check.

Notably, because excessive amounts of heat are removed from the system by the first and second condensers 451, 452, the chamber 403 of Fig. 4 does not include a warmed fluid exit nor a cooled fluid entrance. As such, the system of Fig. 4 does not include an expansion jacket, associated fluidic channels, intake for warmed lower liquid to be sent to an external CDU and corresponding return for cooled lower liquid to be returned back to chamber as exist in the system of Fig. 3. If additional cooling of the lower liquid 302 by an external CDU where to be included, the jacket, fluidic channels, intake and return could be added so long as these components and the external heat exchanger system are sufficiently hermetically sealed to prevent any vapor within the fluid from escaping.

The system of Fig. 4 does include, however, a bellows 439 that is mechanically coupled to the ambient 410 to handle any thermal expansion of the liquids 413, 402. Here, to the extent that either or both of the upper and lower liquids 413, 402 expand with increasing temperature, the height of the upper liquid 413 will rise, the ambient 410 within the chamber 403 will shrink and the bellows 439 will expand to accommodate the increased resulting ambient pressure. The reverse process occurs if either or both of the liquids 413, 402 relax (reduce) their expansion. The bellows 439 can also expand if the vaporization rate of the liquid(s) 413, 402 exceeds the condensation rates of the condensers 451, 452 which can also result in increased ambient 410 pressures. Likewise, the bellows 439 can contract if the condensation rates exceed the vaporization rates.

Notably, in various embodiments, even though the upper liquid 413 is actively cooled by the first condenser 451, the upper liquid 413 remains above the lower liquid 402 because the upper liquid 413 has lower density than the lower liquid 402 (even at its cooler temperature). The upper liquid 413 can have inherently higher boiling point than the lower liquid 402 so that the lower liquid 402 naturally boils while the upper liquid 413 does not boil (there exists a temperature range where, if both liquids 413, 402 have the same temperature within the range, the lower liquid 402 boils but the upper liquid 413 does not boil). Alternatively, the cooling action of the first condenser 451 can prevent the upper liquid 413 from boiling if it has comparable (or even lower) boiling point than the lower liquid 402.

Additionally, the chamber 403 can include one or more mechanical agitation devices (e.g., transducers) 461 that "shakes" the interface between the upper and lower liquids 413, 402 to remove vapor that can become trapped at the interface between the two liquids.

The controller 440 can perform any of the upper liquid draining and recycling operations described above with respect to the single phase immersion system of Fig. 3. Additionally, the controller 440 can induce the agitation device(s) to agitate the upper/lower liquid interface, control respective fluid flows through the respective condensers, monitor evaporation and condensation rates, etc.

In various embodiments, the upper liquid 413 is composed of a polyalphaolefin (PAO) (e.g., PAOₓ where x is within a range of 2 to 8 inclusive), e.g., having a density within a range of 800-900 kg/m³. Examples include Shell S3X, Shell S5X, Shell S5 LV, Electrocool EC-110, EC-120, SmartCoolant SC-003, Renolin, FECC5 Synthetic, Compuzol IM 2015, Castrol ON BOT 2100-DC20, Renolin FECC7, Castrol ON, BOT 2151-DC15. In various embodiments, the lower liquid 302 is composed of a liquid that is denser than the upper liquid, e.g., greater than 1400 kg/m³. Examples include 3M Novec 649, FC-3284, Solvay HT-55, Novec 7200, Novec 7500, Opteon DF-50 and Noah 2100A.

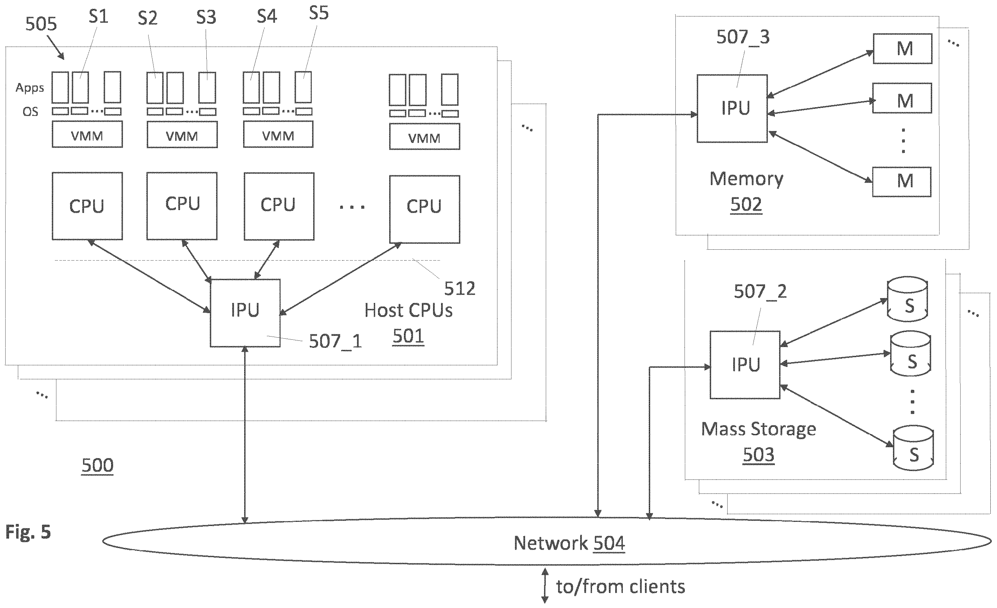

Fig. 5 shows a new, emerging data center environment in which "infrastructure" tasks are offloaded from traditional general purpose "host" CPUs (where application software programs are executed) to an infrastructure processing unit (IPU) or data processing unit (DPU) any/all of which are hereafter referred to as an IPU.

Networked based computer services, such as those provided by cloud services and/or large enterprise data centers, commonly execute application software programs for remote clients. Here, the application software programs typically execute a specific (e.g., "business") end-function (e.g., customer servicing, purchasing, supply-chain management, email, etc.). Remote clients invoke/use these applications through temporary network sessions/connections that are established by the data center between the clients and the applications. A recent trend is to strip down the functionality of at least some of the applications into more finer grained, atomic functions ("micro-services") that are called by client programs as needed. Micro-services typically strive to charge the client/customers based on their actual usage (function call invocations) of a micro-service application.

In order to support the network sessions and/or the applications' functionality, however, certain underlying computationally intensive and/or trafficking intensive functions ("infrastructure" functions) are performed.

Examples of infrastructure functions include routing layer functions (e.g., IP routing), transport layer protocol functions (e.g., TCP), encryption/decryption for secure network connections, compression/decompression for smaller footprint data storage and/or network communications, virtual networking between clients and applications and/or between applications, packet processing, ingress/egress queuing of the networking traffic between clients and applications and/or between applications, ingress/egress queueing of the command/response traffic between the applications and mass storage devices, error checking (including checksum calculations to ensure data integrity), distributed computing remote memory access functions, etc.

Traditionally, these infrastructure functions have been performed by the CPU units "beneath" their end-function applications. However, the intensity of the infrastructure functions has begun to affect the ability of the CPUs to perform their end-function applications in a timely manner relative to the expectations of the clients, and/or, perform their end-functions in a power efficient manner relative to the expectations of data center operators.

As such, as observed in Fig. 5, the infrastructure functions are being migrated to an infrastructure processing unit (IPU) 507. Fig. 5 depicts an exemplary data center environment 500 that integrates IPUs 507 to offload infrastructure functions from the host CPUs 501 as described above.

As observed in Fig. 5, the exemplary data center environment 500 includes pools 501 of CPU units that execute the end-function application software programs 505 that are typically invoked by remotely calling clients. The data center also includes separate memory pools 502 and mass storage pools 505 to assist the executing applications. The CPU, memory storage and mass storage pools 501, 502, 503 are respectively coupled by one or more networks 504.

Notably, each pool 501, 502, 503 has an IPU 507_1, 507_2, 507_3 on its front end or network side. Here, each IPU 507 performs pre-configured infrastructure functions on the inbound (request) packets it receives from the network 504 before delivering the requests to its respective pool's end function (e.g., executing application software in the case of the CPU pool 501, memory in the case of memory pool 502 and storage in the case of mass storage pool 503).

As the end functions send certain communications into the network 504, the IPU 507 performs pre-configured infrastructure functions on the outbound communications before transmitting them into the network 504. The communication 512 between the IPU 507_1 and the CPUs in the CPU pool 501 can transpire through a network (e.g., a multi-nodal hop Ethernet network) and/or more direct channels (e.g., point-to-point links) such as Compute Express Link (CXL), Advanced Extensible Interface (AXI), Open Coherent Accelerator Processor Interface (OpenCAPI), Gen-Z, etc.

Depending on implementation, one or more CPU pools 501, memory pools 502, mass storage pools 503 and network 504 can exist within a single chassis, e.g., as a traditional rack mounted computing system (e.g., server computer). In a disaggregated computing system implementation, one or more CPU pools 501, memory pools 502, and mass storage pools 503 are separate rack mountable units (e.g., rack mountable CPU units, rack mountable memory units (M), rack mountable mass storage units (S)).

In various embodiments, the software platform on which the applications 505 are executed include a virtual machine monitor (VMM), or hypervisor, that instantiates multiple virtual machines (VMs). Operating system (OS) instances respectively execute on the VMs and the applications execute on the OS instances. Alternatively or combined, container engines (e.g., Kubernetes container engines) respectively execute on the OS instances. The container engines provide virtualized OS instances and containers respectively execute on the virtualized OS instances. The containers provide isolated execution environment for a suite of applications which can include, applications for micro-services.

Notably, the respective electronic boards/components of the data center components described above can be cooled according to the teachings described above with respect to Figs. 2, 3 and 4.

Embodiments of the invention may include various processes as set forth above. The processes may be embodied in program code (e.g., machine-executable instructions). The program code, when processed, causes a general-purpose or special-purpose processor to perform the program code's processes. Alternatively, these processes may be performed by specific/custom hardware components that contain hard wired interconnected logic circuitry (e.g., application specific integrated circuit (ASIC) logic circuitry) or programmable logic circuitry (e.g., field programmable gate array (FPGA) logic circuitry, programmable logic device (PLD) logic circuitry) for performing the processes, or by any combination of program code and logic circuitry.

Elements of the present invention may also be provided as a machine-readable storage medium for storing the program code. The machine-readable medium can include, but is not limited to, floppy diskettes, optical disks, CD-ROMs, and magneto-optical disks, FLASH memory, ROMs, RAMs, EPROMs, EEPROMs, magnetic or optical cards or other type of media/machine-readable medium suitable for storing electronic instructions.

In the foregoing specification, the invention has been described with reference to specific exemplary embodiments thereof. It will, however, be evident that various modifications and changes may be made thereto without departing from the broader spirit and scope of the invention as set forth in the appended claims. The specification and drawings are, accordingly, to be regarded in an illustrative rather than a restrictive sense.

## Claims

1. An apparatus, comprising:
a chamber to contain one or more electronic components, a first liquid and a second liquid, the electronics to be immersed in the second liquid, the first liquid having less density than the second liquid so that the first liquid floats above the second liquid, the first liquid to return second liquid molecules received from the second liquid back to the second liquid, the chamber comprising a first fluidic channel to drain the first liquid from the chamber while the second liquid is within the chamber.

2. The apparatus of claim 1 wherein the chamber comprises a second fluidic channel to allow the second liquid to escape the chamber in response to thermal expansion of the second liquid.

3. The apparatus of claim 2 wherein the second fluidic channel is coupled to a third fluidic channel that is to direct warmed second liquid to a CDU.

4. The apparatus of claims 1, 2 or 3 wherein the chamber comprises a valve that is coupled to the first fluidic channel to control the drain of the first liquid from the chamber.

5. The apparatus of claims 1, 2, 3 or 4 further comprising a reservoir that is coupled to the first fluidic channel, the reservoir to collect the first liquid after it drains from the chamber.

6. The apparatus of claim 1 wherein the second liquid is a two phase cooling immersion liquid.

7. The apparatus of claim 6 further comprising a condenser to be placed within the first liquid.

8. The apparatus of claim 1 wherein the first liquid is to exhibit a lower vapor pressure than the second liquid.

9. An apparatus, comprising
means for performing the following within a chamber that contains one or more electronic components, a first liquid and a second liquid, wherein, the electronics are immersed in the second liquid, and wherein, the first liquid has less density than the second liquid so that the first liquid floats above the second liquid:
the first liquid returning second liquid molecules received by the first liquid from the second liquid back to the second liquid; and,
draining the first liquid from the chamber while the second liquid remains within the chamber.

10. The apparatus of claim 9 further comprises means for draining the first liquid through a fluidic channel within the chamber.

11. The apparatus of claim 9 further comprising means for filtering the drained first liquid.

12. The apparatus of claim 10 further comprising means for pumping the drained and filtered first liquid back into the chamber.

13. The apparatus of claim 9 further comprising means for directing a portion of the second liquid to a CDU, the second liquid having escaped the chamber in response to thermal expansion of the second liquid.

14. The apparatus of claim 9 further comprising means for removing heat from the first liquid with a first condenser that is located within the first liquid.

15. A data center comprising the subject matter of any of claims 1 through 14.
